# EUROPÄISCHE PATENTSCHRIFT

(11) **EP 2 997 800 B1**
(45) Veröffentlichungstag und Bekanntmachung des Hinweises auf die Patenterteilung: **15.11.2017**
(21) Anmeldenummer: 14721794.7
(22) Anmeldetag: 17.04.2014
(51) Int. Cl.: H05K 5/02, H05K 7/20

(54) **VERFAHREN UND VORRICHTUNG ZUR KÜHLUNG WENIGSTENS EINES WÄRMEERZEUGENDEN BAUTEILS SOWIE VERWENDUNG DES VERFAHRENS**
METHOD AND DEVICE FOR COOLING AT LEAST ONE HEAT-GENERATING COMPONENT AND USE OF SAID METHOD
PROCÉDÉ ET DISPOSITIF POUR REFROIDIR AU MOINS UN ÉLÉMENT GÉNÉRANT DE LA CHALEUR AINSI QU'UTILISATION DU PROCÉDÉ

(30) Priorität: 17.05.2013 DE 102013209269
(43) Veröffentlichungstag der Anmeldung: 23.03.2016
(73) Patentinhaber: Robert Bosch GmbH, 70442 Stuttgart (DE)
(72) Erfinder: KILAST, Bernd, 71277 Rutesheim (DE); KUEHN, Timo, 76307 Karlsbad (DE)
(86) Internationale Anmeldenummer: PCT/EP2014/057923
(87) Internationale Veröffentlichungsnummer: WO 2014/183954

(56) Entgegenhaltungen:
- JP-A- H01 157 596
- US-A- 5 934 368

## Beschreibung

### Stand der Technik

Die Erfindung betrifft ein Verfahren und eine Vorrichtung zur Kühlung wenigstens eines wärmeerzeugenden Bauteils nach den Oberbegriffen der beiden unabhängigen Ansprüche. Ferner betrifft die Erfindung die Verwendung eines erfindungsgemäßen Verfahrens bzw. einer erfindungsgemäßen Vorrichtung.

Ein Verfahren bzw. eine Vorrichtung nach dem Oberbegriff der beiden unabhängigen Ansprüche ist aus der JP H 01 157 596 A bekannt. Dabei wird die in einem Gehäuse befindliche Luft mittels einer Vakuumpumpe abgesaugt, so dass in dem Gehäuseinnenraum gegenüber der Umgebung ein reduzierter Druck herrscht. Darüber hinaus sind innerhalb des Gehäuses auf Trägerelementen aktive Bauelemente angeordnet, welche über eine Kühleinrichtung gekühlt werden.

Aus der US 5,934,368 ist es darüber hinaus bekannt, zur Kühlung von Bauteilen in einem Gehäuse die in dem Gehäuse befindliche Luft abzusaugen und gleichzeitig durch in das Gehäuse nachströmende Luft zu ersetzen. Die nachströmende Luft kann dabei durch eine Heizeinrichtung oder eine Kondensiereinrichtung vorbehandelt sein.

Aus der DE 10 2006 023 134 B4 ist es weiterhin bereits bekannt, die Kondensatbildung in einem elektronischen Gerät dadurch zu reduzieren, dass das Luftvolumen in dem Gehäuse verringert wird. Dies wird mittels eines speziellen Einlegekörpers erreicht, der aus mindestens zwei unterschiedlichen Materialien besteht, die unterschiedliche Wärmekapazitäten oder Wärmeleitfähigkeiten aufweisen.

Aus der DE 10 2010 038 876 A1 ist es bekannt, in einem Gehäuse zur Vermeidung eines erhöhten Gehäuseinnendrucks den Druck auf den Umgebungsdruck zu reduzieren.

Aus dem Stand der Technik ist es darüber hinaus bekannt, die Auswirkungen von Kondensat in einem Steuergerät durch eine Lackierung der Leiterplatte zu reduzieren. Alternativ kommt eine Schutzschicht aus Fluorpolymeren oder Parylenen zum Einsatz.

Zuletzt ist es bekannt, durch den Einsatz von Gebläseeinrichtungen o.ä. die in einem Steuergerät befindliche Luft aus dem Steuergerät abzusaugen, wodurch gleichzeitig eine Kühlung des Gehäuseinnenraums erfolgt.

### Offenbarung der Erfindung

Ausgehend von dem dargestellten Stand der Technik liegt der Erfindung die Aufgabe zugrunde, ein Verfahren bzw. eine Vorrichtung zur Kühlung wenigstens eines wärmeerzeugenden Bauteils nach den Oberbegriffen der beiden unabhängigen Ansprüche derart weiterzubilden, dass das Verhältnis zwischen abgesaugter Luft und nachströmender Luft regelbar ist, um stets einen optimalen Wirkungsgrad zu erzielen bzw. Kondensatbildung in dem Gehäuse sicher zu vermeiden.

Diese Aufgabe wird erfindungsgemäß bei einem Verfahren bzw. einer Vorrichtung zur Kühlung wenigstens eines wärmeerzeugenden Bauteils mit den Merkmalen der beiden unabhängigen Ansprüche gelöst.

Die Erfindung macht sich den bereits aus der JP H 01 157 596 A bekannten physikalischen Effekt zunutze, dass bei einer Absenkung des Luftdrucks bei ansonsten gleichen Bedingungen die Taupunkttemperatur herabgesetzt wird. Mit anderen Worten gesagt bedeutet dies, dass ein Phasenübergang bzw. eine Kondensatbildung erst bei einer tieferen Temperatur auftritt. Wenn somit in dem Gehäuseinnenraum beispielsweise eine bestimmte Feuchtigkeitsmenge vorhanden ist, wird durch eine Absenkung des Luftdrucks der Effekt erzielt, dass trotz der infolge der Kühleinrichtung abgesenkten Temperatur in dem Innenraum, die beispielsweise bei normalem Umgebungsdruck zur Kondensatbildung führt, die Kondensatbildung unterdrückt wird, da diese nun erste bei einer tieferen Temperatur auftritt. Dadurch, dass die in dem Gehäuse befindliche Luft erfindungsgemäß durch eine Absaugeinrichtung aus dem Gehäuse abgesaugt und durch aus der Umgebung nachströmende Luft ersetzt wird, findet ein Abtransport der Feuchtigkeit bzw. der Wärme aus dem Gehäuseinnenraum statt, wobei die in den Gehäuseinnenraum nachströmende Luft zur Aufnahme der Wärme bzw. der Feuchtigkeit dient. Die Regelung des Luftaustausches erfolgt durch eine Ventileinrichtung, durch die die gewünschte Druckabsenkung eingestellt werden kann.

Vorteilhafte Weiterbildungen des erfindungsgemäßen Verfahrens bzw. der Vorrichtung sind in den jeweiligen Unteransprüchen aufgeführt.

Ganz besonders bevorzugt bei einem derartigen Verfahren ist es, wenn die nachströmende Luft abgekühlt und kondensiert wird. Mit anderen Worten gesagt bedeutet dies, dass die in das Gehäuse einströmende Luft durch Abkühlung kondensiert und somit die in ihr befindliche Feuchtigkeit entzogen wird, so dass eine besonders trockene Luft zur Kühlung in dem Gehäuse verwendet wird.

Vorrichtungstechnisch findet die Abkühlung bzw. Kondensation der in den Gehäuseinnenraum nachströmenden Luft bevorzugt dadurch statt, dass die nachströmende Luft durch eine Kondensiereinrichtung durchführbar ist. Insbesondere ist es dabei vorgesehen, dass die Kondensiereinrichtung in Wirkverbindung mit der Kühleinrichtung angeordnet ist. Bei der Kühleinrichtung kann es sich dabei um dieselbe Kühleinrichtung handeln, die zur Kühlung des Gehäuses bzw. des Gehäuseinnenraums verwendet wird, oder um eine separate Kühleinrichtung, beruhend auf einem anderen Kühlprinzip oder mit einer unterschiedlichen Kühlleistung.

In besonders bevorzugter Ausbildung der Kühleinrichtung wird vorgeschlagen, dass diese in Form einer Wärmesenke mit einer Kühlplatte ausgebildet und zumindest in wärmeleitendem Kontakt mit einem Teilbereich des Gehäuses angeordnet ist.

Das erfindungsgemäße Verfahren bzw. die erfindungsgemäße Vorrichtung zur Kühlung wenigstens eines wärmeerzeugenden Bauteils findet bevorzugt Verwendung zur Kühlung elektrischer und/oder elektronischer Komponenten eines Steuergeräts. Bevorzugte Einsatzbereiche derartiger Steuergeräte sind insbesondere Kraftfahrzeuge, es ist jedoch auch der Einsatz in stationären Anlagen bzw. Aggregaten denkbar.

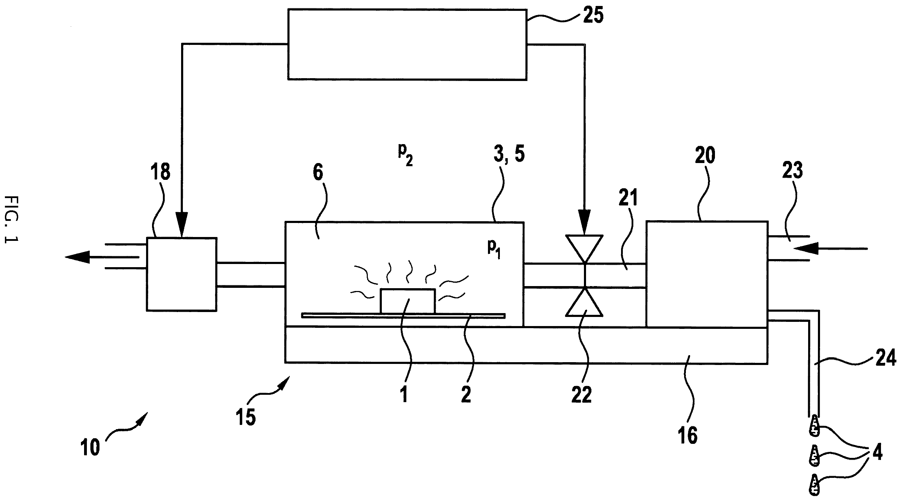

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in der einzigen Figur eine schematische Darstellung einer Vorrichtung zur Kühlung wenigstens eines wärmeerzeugenden Bauteils, das in einem Steuergerät angeordnet ist.

In der einzigen Figur ist eine Vorrichtung 10 zur Kühlung wenigstens eines wärmeerzeugenden elektrischen bzw. elektronischen Bauteils 1 dargestellt. Das Bauteil 1 ist z.B. auf einer Leiterplatte 2 in an sich bekannter Art und Weise angeordnet, wobei sich die Leiterplatte 2 in einem Gehäuse 3 befindet, das Bestandteil eines Steuergeräts 5 ist. Beim Betrieb des Steuergeräts 5 über eine nicht dargestellte Spannungsversorgung erzeugt das Bauteil 1 Wärme, die zumindest teilweise in den Innenraum 6 des Gehäuses 3 als Strahlungswärme abgestrahlt wird. Darüber hinaus kann es vorgesehen sein, dass das Bauteil 1 entweder unmittelbar, oder über die Leiterplatte 2, in wärmeleitendem Kontakt mit dem Gehäuse 3 angeordnet ist.

Um das wärmeerzeugende Bauteil 1 bzw. den Innenraum 6 des Gehäuses 3 zu kühlen ist eine Kühleinrichtung 15 vorgesehen, die beispielhaft, jedoch nicht einschränkend, als Kühlplatte 16 ausgebildet ist. Die Kühlplatte 16 wird zum Beispiel von einem Kühlmittel in nicht dargestellten Kühlmittelkanälen durchströmt. Alternativ wirkt die Kühlplatte 16 ohne Kühlmittel durch ihre relativ große Oberfläche als Kühlkörper für das Gehäuse 3 des Steuergeräts 5. Die Kühlplatte 16 ist zumindest mittelbar in wärmeleitendem Kontakt, insbesondere in Anlagekontakt mit dem Gehäuse 3 angeordnet.

Darüber hinaus ist in Wirkverbindung mit dem Gehäuse 3 eine Einrichtung 18 zur Absenkung des Luftdrucks p₁ in dem Innenraum 6 des Gehäuses 3 angeordnet. Die Einrichtung 18 ist im einfachsten Fall als Ventilator bzw. Sauggebläse ausgebildet, es sind jedoch auch andere Ausführungsformen denkbar. Durch die Einrichtung 18 wird zum einen die in dem Innenraum 6 befindliche Luft aus dem Gehäuse 3 abgesaugt und an die Umgebung abgegeben, zum anderen findet, wie erwähnt, eine Absenkung des Luftdrucks p₁ statt, derart, dass der Luftdruck p₁ unter dem Umgebungsdruck p₂ ist.

Die durch die Einrichtung 18 aus dem Innenraum 6 des Gehäuses 3 abgesaugte Luft wird optional zumindest teilweise durch in das Gehäuse 3 nachströmende Luft ersetzt. Dazu ist das Gehäuse 3 in Wirkverbindung mit einer im Ausführungsbeispiel außerhalb des Gehäuses 3 angeordneten Kondensiereinrichtung 20 angeordnet. Die Kondensiereinrichtung 20 ist über einen Verbindungskanal 21, in dem ein Ventileinrichtung 22 angeordnet ist, mit dem Innenraum 6 des Gehäuses 3 verbunden. Über einen Eintrittstutzen 23 der Kondensiereinrichtung 20 wird aus der Umgebung Luft in die Kondensiereinrichtung 20 angesaugt, welche ebenfalls beispielhaft in Wirkverbindung mit der Kühleinrichtung 15 angeordnet ist. Dadurch findet eine Abkühlung der in der Kondensiereinrichtung 20 befindlichen, gerade angesaugten Luft bis unterhalb deren Taupunkt statt, so dass die in der angesaugten Luft befindliche Luftfeuchtigkeit in Form von Kondensat 4 über einen Ablaufstutzen 24 aus der Kondensiereinrichtung 20 abgeführt werden kann.

Sowohl die Regelung der Einrichtung 18, als auch die Verstellung der Ventileinrichtung 22 wird durch eine vorzugsweise gemeinsame Steuereinrichtung 25 bewirkt. Dadurch kann insbesondere auch die gewünschte Druckabsenkung eingestellt werden. Weiterhin kann es vorgesehen sein, dass beispielsweise innerhalb des Gehäuses 3 nicht dargestellte Sensoren angeordnet sind, die mit der Steuereinrichtung 25 gekoppelt sind. Über derartige Sensoren lässt sich insbesondere der in dem Innenraum 6 herrschende Luftdruck p₁ sowie ggf. die Innenraumtemperatur erfassen, so dass die Steuereinrichtung 25 die Einrichtung 18 sowie die Ventileinrichtung 22 bedarfsgerecht ansteuert.

Das soweit beschriebene Verfahren bzw. die Vorrichtung 10 zur Kühlung des Bauteils 1 können in vielfältiger Art und Weise abgewandelt bzw. modifiziert werden, ohne vom Erfindungsgedanken abzuweichen.

## Patentansprüche

1. Verfahren zur Kühlung wenigstens eines wärmeerzeugenden Bauteils (1), wobei das wenigstens eine Bauteil (1) in einem Gehäuse (3) angeordnet ist, wobei das wenigstens eine Bauteil (1) zumindest mittelbar in Wirkverbindung mit einer Kühleinrichtung (15) angeordnet ist, wobei durch Absenkung des Luftdrucks (p₁) in dem Gehäuse (3), zumindest in dem Teilbereich des Gehäuses (3), in dem das wenigstens eine wärmeerzeugende Bauteil (1) angeordnet ist, gegenüber dem Luftdruck (p₂) in der unmittelbaren äußeren Umgebung des Gehäuses (3) die Taupunkttemperatur in dem Gehäuse (3) im Bereich des wenigstens einen wärmeerzeugenden Bauteils (1) herabgesetzt wird,
**dadurch gekennzeichnet,**
**dass** die in dem Gehäuse (3) befindliche Luft durch eine Einrichtung (18) aus dem Gehäuse (3) abgesaugt und durch aus der Umgebung nachströmende Luft ersetzt wird, und dass der Zufluss von Umgebungsluft in das Gehäuse (3) mittels einer Ventileinrichtung (22) gesteuert wird, wobei die Ventileinrichtung (22) und die Einrichtung (18) zur Absenkung des Luftdrucks (p₁) in dem Gehäuse (3) von einer insbesondere gemeinsamen Steuereinrichtung (25) angesteuert werden.

2. Verfahren nach Anspruch 1,
**dadurch gekennzeichnet,**
**dass** die nachströmende Luft abgekühlt und kondensiert wird.

3. Vorrichtung (10) zur Kühlung wenigstens eines wärmeerzeugenden Bauteils (1), insbesondere nach einem Verfahren nach Anspruch 1 oder 2, mit einem Gehäuse (3) zur Aufnahme des wenigstens einen wärmeerzeugenden Bauteils (1) und einer zumindest mittelbar in Wirkverbindung mit dem Bauteil (1) angeordneten Kühleinrichtung (15), wobei eine Einrichtung (18) zur Absenkung des Luftdrucks (p₁) in dem Gehäuse (3) gegenüber dem Luftdruck (p₂) in der Umgebung des Gehäuses (3) vorgesehen ist,
**dadurch gekennzeichnet,**
**dass** eine mit dem Gehäuse (3) verbundene oder am Gehäuse (3) angeordnete Einrichtung zum Nachströmen von Umgebungsluft in das Gehäuse (3) vorgesehen ist, dass der Zufluss von Umgebungsluft in das Gehäuse (3) mittels einer Ventileinrichtung (22) steuerbar ist, und dass die Ventileinrichtung (22) und die Einrichtung (18) zur Absenkung des Luftdrucks (p₁) in dem Gehäuse (3) von einer insbesondere gemeinsamen Steuereinrichtung (25) ansteuerbar sind.

4. Vorrichtung nach Anspruch 3,
**dadurch gekennzeichnet,**
**dass** die nachströmende Luft durch eine Kondensiereinrichtung (20) durchführbar ist.

5. Vorrichtung nach Anspruch 4,
**dadurch gekennzeichnet,**
**dass** die Kondensiereinrichtung (20) in Wirkverbindung mit der Kühleinrichtung (15) angeordnet ist.

6. Vorrichtung nach einem der Ansprüche 3 bis 5,
**dadurch gekennzeichnet,**
**dass** die Kühleinrichtung (15) in Form einer Wärmesenke mit einer Kühlplatte (16) ausgebildet und zumindest in wärmeleitendem Kontakt mit einem Teilbereich des Gehäuses (3) angeordnet ist.

7. Verwendung eines Verfahrens nach einem der Ansprüche 1 oder 2 und/oder einer Vorrichtung (10) nach einem der Ansprüche 3 bis 6 zur Kühlung elektrischer und/oder elektronischer Komponenten eines Steuergeräts (5).

## Claims

1. Method for cooling at least one heat-generating component (1), the at least one component (1) being arranged in a housing (3), the at least one component (1) being arranged at least indirectly in an operative connection with a cooling device (15), the dew point temperature in the housing (3) being lowered in the region of the at least one heat-generating component (1) by way of decreasing of the air pressure (p₁) in the housing (3), at least in that part region of the housing (3), in which the at least one heat-generating component (1) is arranged, in comparison with the air pressure (p₂) in the immediate external surroundings of the housing (3), **characterized in that** the air which is situated in the housing (3) is extracted from the housing (3) by way of a device (18) and is replaced with incoming air from the surroundings, and **in that** the inflow of surrounding air into the housing (3) is controlled by means of a valve device (22), the valve device (22) and the device (18) for decreasing the air pressure (p₁) in the housing (3) being actuated by an, in particular, common control device (25).

2. Method according to Claim 1, **characterized in that** the incoming air is cooled and condensed.

3. Apparatus (10) for cooling at least one heat-generating component (1), in particular according to a method according to Claim 1 or 2, having a housing (3) for receiving the at least one heat-generating component (1) and a cooling device (15) which is arranged at least indirectly in an operative connection with the component (1), a device (18) being provided for decreasing the air pressure (p₁) in the housing (3) in comparison with the air pressure (p₂) in the surroundings of the housing (3), **characterized in that** a device which is connected to the housing (3) or is arranged on the housing (3) is provided for replenishing surrounding air into the housing (3), **in that** the inflow of surrounding air into the housing (3) can be controlled by means of a valve device (22), and **in that** the valve device (22) and the device (18) for decreasing the air pressure (p₁) in the housing (3) can be actuated by an, in particular, common control device (25).

4. Apparatus according to Claim 3, **characterized in that** the incoming air can be guided through a condensing device (20).

5. Apparatus according to Claim 4, **characterized in that** the condensing device (20) is arranged in an operative connection with the cooling device (15).

6. Apparatus according to one of Claims 3 to 5, **characterized in that** the cooling device (15) is configured in the form of a heat sink with a cooling plate (16) and is arranged at least in thermally conducting contact with a part region of the housing (3).

7. Use of a method according to either of Claims 1 and 2 and/or an apparatus (10) according to one of Claims 3 to 6 for cooling electric and/or electronic components of a control unit (5).

## Revendications

1. Procédé pour refroidir au moins un composant générant de la chaleur (1), l'au moins un composant (1) étant disposé dans un boîtier (3), l'au moins un composant (1) étant disposé au moins indirectement en liaison fonctionnelle avec un dispositif de refroidissement (15), la température du point de rosée dans le boîtier (3) étant abaissée dans la région de l'au moins un composant générant de la chaleur (1) par abaissement de la pression d'air (p₁) dans le boîtier (3) par rapport à la pression d'air (p₂) dans l'environnement extérieur immédiat du boîtier (3), au moins dans la région partielle du boîtier (3) dans laquelle l'au moins un composant générant de la chaleur (1) est disposé,
**caractérisé en ce que**
l'air se trouvant dans le boîtier (3) est aspiré hors du boîtier (3) par un dispositif (18) et est remplacé par de l'air affluant à partir de l'environnement, et **en ce que** l'afflux d'air de l'environnement dans le boîtier (3) est commandé au moyen d'un dispositif de soupape (22), le dispositif de soupape (22) et le dispositif (18) pour abaisser la pression d'air (p₁) dans le boîtier (3) étant commandés par un dispositif de commande (25), en particulier commun aux deux.

2. Procédé selon la revendication 1,
**caractérisé en ce que**
l'air affluant est refroidi et condensé.

3. Dispositif (10) pour refroidir au moins un composant générant de la chaleur (1), en particulier selon un procédé selon la revendication 1 ou 2, comprenant un boîtier (3) pour recevoir l'au moins un composant générant de la chaleur (1) et un dispositif de refroidissement (15) disposé au moins indirectement en liaison fonctionnelle avec le composant (1), un dispositif (18) pour abaisser la pression d'air (p₁) dans le boîtier (3) par rapport à la pression d'air (p₂) dans l'environnement du boîtier (3) étant prévu,
**caractérisé en ce**
**qu'**un dispositif connecté au boîtier (3) ou disposé sur le boîtier (3) pour l'afflux d'air de l'environnement dans le boîtier (3) est prévu, en ce que l'afflux d'air de l'environnement dans le boîtier (3) peut être commandé au moyen d'un dispositif de soupape (22) et en ce que le dispositif de soupape (22) et le dispositif (18) pour abaisser la pression d'air (p₁) dans le boîtier (3) peuvent être commandés par un dispositif de commande (25), en particulier commun aux deux.

4. Dispositif selon la revendication 3,
**caractérisé en ce que** l'afflux d'air peut être conduit à travers un dispositif de condensation (20).

5. Dispositif selon la revendication 4,
**caractérisé en ce que**
le dispositif de condensation (20) est disposé en liaison fonctionnelle avec le dispositif de refroidissement (15).

6. Dispositif selon l'une quelconque des revendications 3 à 5,
**caractérisé en ce que** le dispositif de refroidissement (15) est réalisé sous la forme d'un puits de chaleur avec une plaque de refroidissement (16) et est disposé au moins en contact thermoconducteur avec une région partielle du boîtier (3).

7. Utilisation d'un procédé selon l'une quelconque des revendications 1 ou 2 et/ou d'un dispositif (10) selon l'une quelconque des revendications 3 à 6 pour refroidir des composants électriques et/électroniques d'un appareil de commande (5).
